# FASCICULE DE BREVET EUROPEEN

(11) **EP 0 408 419 B1**
(45) Date de publication et mention de la délivrance du brevet: **05.04.1995**
(21) Numéro de dépôt: 90401883.5
(22) Date de dépôt: 29.06.1990
(51) Int. Cl.: G11C 16/04, G11C 17/16

(54) **Utilisation d'une cellule MOS pragrammable électriquement pour réaliser un fusible**
Verwendung einer elektrisch programmierbaren MOS-Zelle als Schmelzsicherung
Use of an electrically programmable MOS cell to implement a fuse

(30) Priorité: 13.07.1989 FR 8909547
(43) Date de publication de la demande: 16.01.1991
(73) Titulaire: GEMPLUS CARD INTERNATIONAL, F-13420 Gemenos (FR)
(72) Inventeur: Kowalski, Jacek, F-75116 Paris (FR)
(74) Mandataire: Schmit, Christian Norbert Marie

(56) Documents cités:
- US-A- 4 203 158
- INTERNATIONAL ELECTRON DEVICES MEETING, Washington, DC, décembre 1985, pages639-642; N. SATO et al.: "A new programmable cell utilizing insulatorbreakdown"
- PATENT ABSTRACTS OF JAPAN, vol. 9, no. 170 (P-373)[1893], 16 juillet 1985;& JP-A-60 47 297 (NIPPON DENKI K.K.) 14-03-1985
- IBM TECHNICAL DISCLOSURE BULLETIN, vol. 23, no. 2, juillet 1980, pages 543-545,New York, US; A. BHATTACHARYYA et al.: "Hardcoupled sandwiched high densityfloating gate cell"

## Description

L'invention se rapporte au domaine des circuits intégrés MOS, Métal/Oxyde/Semi-conducteur et plus particulièrement à une utilisation d'une cellule MOS programmable électriquement pour réaliser un fusible.

L'utilisation de fusibles dans les circuits intégrés est très répandue, notamment pour la programmation de mémoires mortes ou pour obtenir une configuration de circuit, après le claquage du ou des fusibles, différente de la configuration initiale. C'est le cas par exemple des circuits intégrés pour cartes à puces où les fusibles après claquage, permettent de bloquer l'accès à certaines zones de circuit. En général, il n'est pas possible de fixer cette configuration lors de la fabrication du circuit, car l'accès à ces zones doit être possible pour le test du circuit et pour sa personnalisation. Ce n'est qu'ensuite que l'accès à ces zones doit être interdit. Pour cette application, la sécurité de la carte est étroitement liée à un bon claquage des fusibles.

D'autres applications pour les fusibles dans les circuits-intégrés sont mises en oeuvre, par exemple dans les mémoires haute capacité pour la redondance, les colonnes (ou les lignes) défectueuses étant remplacées après claquage d'un fusible correspondant par des colonnes (ou des lignes) supplémentaires.

On connaît différent types de fusibles utilisables dans les circuits intégrés notamment dans les mémoires programmables ou l'inscription est faite par claquage de fusible ou de jonction. Le fusible est réalisé sous forme d'une mince couche de métal d'alliage de nickel et de chrome, ou surtout de Silicium polycristallin de meilleure fiabilité détruite par application d'une puissance élevée. Le claquage de jonction nécessite lui aussi des conditions de claquage bien maîtrisées avec des courants assez élevés.

La limitation principale des fusibles classiques est donc la nécessité de mettre en oeuvre de grandes puissances de claquage, par exemple des courants de 100 à 200 mA sous 10 à 20V. Or ceci est incompatible de l'évolution de la technologie des circuits intégrés où la tendance est à la diminution de la consommation des circuits, et à la diminution des tensions internes et des tensions claquage des diodes ou des jonctions.

Ainsi il est plus difficile avec la technologie actuelle de claquer correctement un fusible dans les circuits intégrés CMOS que dans les circuits d'il y a quelques années surtout du fait que la tension appliquée pendant le claquage doit être beaucoup plus basse qu'auparavant.

D'autres problèmes sont également mal résolus, par exemple les claquages parasites de fusibles mis en parallèle avec des fusibles à claquer : en effet, durant le claquage d'un fusible, la conduction du transistor de commande de claquage peut provoquer le claquage "parasite" d'un fusible non souhaité. La seule façon de résoudre ce problème consiste à diminuer la tension de claquage, mais cela rend plus difficile le claquage du fusible souhaité.

Un autre problème résulte du claquage du fusible par décharge électrostatique. En effet ce claquage intervient dans des conditions qui se rapprochent aujourd'hui des caractéristiques requises sur les entrées/sorties des circuits. Ainsi, le claquage par décharge électrostatique peut intervenir pour 500V alors que les tensions d'entrées sorties atteignent fréquemment 5000V. L'utilisation de fusibles sur les broches d'entrées/sorties et leur claquage durant l'application est donc impossible.

Pour remédier à ces inconvénients, des concepteurs de circuits intégrés ont mis au point des cellules mémoires ou "points mémoires" MOS programmables électriquement (EPROM ou EEPROM) dont l'état logique, circuit ouvert (1) ou passant (0), est déterminé par l'existence ou non de charges accumulées sur une grille flottante (non connectée). La programmation d'une telle cellule, c'est à dire le passage de l'état "circuit ouvert" à l'état "circuit passant" équivaut à décaler le seuil de conduction par ces charges accumulées sur la grille flottante.

Une telle cellule à deux états logiques est équivalente à un fusible sauf en ce qui concerne l'irréversibilité. En effet, les charges accumulées sur la grille flottante peuvent être supprimées par exemple par échauffement du circuit, par radioactivité, par effet d'ondes électromagnétiques, ou encore par compensation de ces charges par des charges stockées dans l'oxyde mince des cellules, entre les électrodes de source et de drain et la grille flottante. Or pour les applications du type cartes à puces, toute la sécurité repose sur le fait qu'il doit être impossible, après claquage du fusible, de le ramener dans l'état logique existant avant le claquage.

On pourra se reporter d'autre part à l'état de la technique constitué par le document IEEE - 1985 intitulé "A new programmable cell utilizing insulator breakdown" pages 639 - 642 de N - SATO et al dans lequel une cellule BIC (Breakdown insulator cell) est décrite.

Cette cellule comporte une couche fine d'isolant couvrant une zone de contact sur une couche de diffusion N+, et une électrode en aluminium connectée à la surface d'isolation.

La programmation de la cellule se fait par application d'impulsions sur l'électrode en aluminium de manière à claquer la couche d'isolant, l'électrode étant alors reliée à la région N+. Cette cellule est destinée à la réalisation de mémoires PROM.

On pourra également se reporter à l'état de la technique constitué par le document Patent Abstract of Japan, vol.9, n° 170 du 16 juillet 1985 dans lequel des transistors FET d'un plan mémoire ROM ont une grille flottante reliée au même potentiel que la grille de commande.

L'invention a pour object l'utilisation d'un fusible à structure Métal/Oxyde/Semi-conducteur qui ne présente pas les inconvénients des fusibles classiques en ce qui concerne les puissances de claquage nécessaires et qui ne présente pas les inconvénients des cellules MOS programmables d'un état initial à un autre état par stockage de charges en ce qui concerne la sécurité.

Selon l'invention on propose l'utilisation d'une cellule MOS programmable électriquement pour réaliser un fusible, la cellule comportant deux électrodes (A,S) formées par dopage d'un substrat, une première grille (G2) formée de silicium-polycristallin recouvrant partiellement l'une (A) des deux électrodes dont elle est séparée par une couche d'oxyde de silicium amincie pour former une fenêtre tunnel (F), et une seconde grille (G1) séparée de la première par une couche d'oxyde, les deux grilles (G1, G2) étant interconnectées pour permettre l'application d'un champ électrique de claquage irréversible de l'oxyde formant la fenêtre (F).

L'invention sera mieux comprise et d'autres caractéristiques apparaîtront à l'aide de la description qui suit en références aux figures annexées :
- les figures 1a et 1b représentent le schéma en coupe d'une cellule MOS programmable à grille flottante connue, et le schéma électrique symbolique équivalent;
- les figures 2a et 2b représentent le schéma du fusible MOS à claquage, utilisable selon l'invention, et le schéma électrique symbolique correspondant;
- la figure 3 est le schéma du montage nécessaire au claquage du fusible;
- la figure 4 est un chronogramme des tensions de commande correspondantes.

La figure la représente une cellule mémoire MOS programmable et effaçable électriquement à effet tunnel connue : le substrat silicium est dopé N⁺ pour former d'une part la source S, d'autre part le drain D, puis est recouvert d'une couche d'oxyde de silicium, d'une grille FG de silicium polycristallin dite grille "flottante" parce que non connectée, et d'une seconde grille G sur laquelle est prévu un point de contact. La grille flottante forme avec le drain sur une partie de sa longueur, une fenêtre tunnel mince F, typiquement par une épaisseur de 0,01 micromètre d'oxyde obtenu au moins en partie par croissance. Le point de contact de la grille G est raccordée à une ligne de mots. Comme indiqué ci-dessus, la programmation d'une telle cellule est obtenue par effet tunnel, un champ électrique intense, typiquement 10 MV/cm, permettant aux charges électriques de traverser la fenêtre d'oxyde du tunnel et de se retrouver stockées sur la grille flottante FG. Suivant la direction du champ électrique, les charges stockées sont soit des trous, soit des électrons. Pour une fenêtre d'oxyde de 0,01 micromètre, il faut appliquer une tension de 10 V sur la grille flottante FG pour obtenir un champ électrique suffisant pour permettre la traversée des charges par effet tunnel.

Pour cela il faut que la tension appliquée à la grille G par la "ligne de mots" soit déterminée en tenant compte du coefficient de couplage capacitif entre les deux grilles G et FG. Par exemple, si ce coefficient de couplage est égal à 0.5, la tension appliquée à G doit être égale à 20 V pour obtenir 10 V par couplage capacitif sur la grille FG et déclencher l'effet tunnel, le drain étant maintenu à OV. De la même façon, il suffit d'appliquer 20 V sur le drain de la cellule en maintenant la grille à OV pour déclencher le transfert de charges par effet tunnel avec un champ électrique inversé. Une telle cellule lorsqu'elle est "effacée" (électrons stockées sur la grille flottante FG) a sa tension du seuil VT_{O} égale à environ 5V; une cellule "programmée" (trous stockés sur la grille flottante) a sa tension de seuil VT₁ égale à environ 3V. Si pour la lecture, une tension de 2V est appliquée sur la grille G, la cellule effacée, ne conduit pas et la cellule programmée conduit.

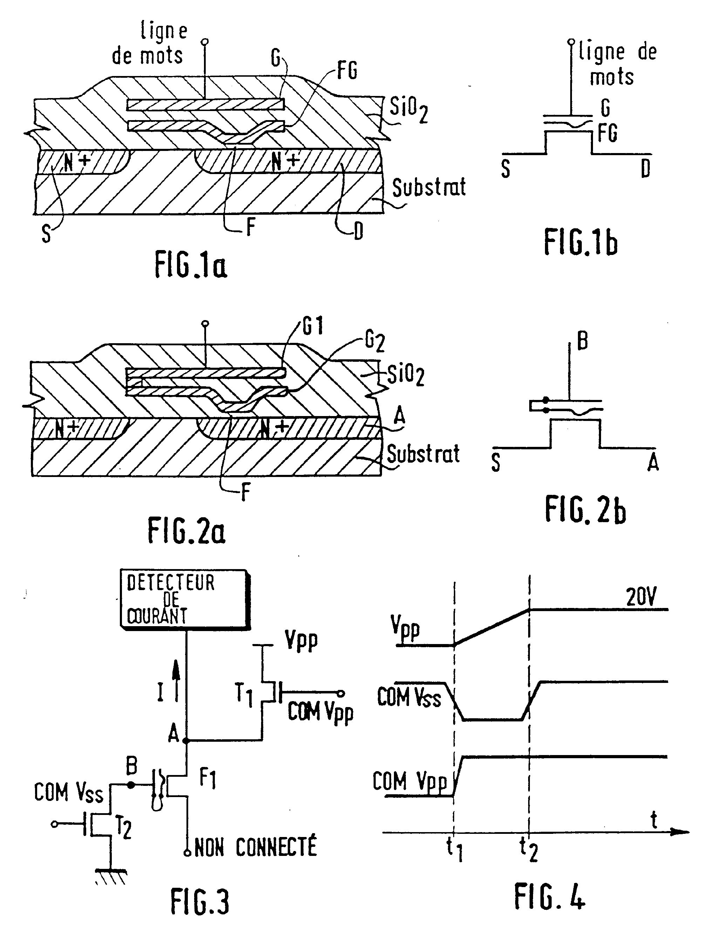

L'oxyde de la fenêtre tunnel entre la grille FG et le drain est un élément très fragile du fait de sa faible épaisseur. Cette structure d'oxyde en couche mince entre le drain et la grille pour former la fenêtre est nécessaire pour que la conduction par effet tunnel puisse s'effectuer. Cet effet à lieu juste avant que le claquage électrostatique de l'oxyde ne se produise. A titre d'exemple, si l'effet tunnel est déclenché par un champ électrique compris entre 8 et 10MV/cm, le claquage de l'oxyde se produit pour un champ électrique d'environ 12MV/cm ou même inférieur si le champ électrique est appliqué brusquement. Dans les cellules EEPROM de ce type, la tension nécessaire lors de la programmation est augmentée très lentement, 20 V/ms, pour éviter le claquage de l'oxyde . La figure 1b représente le schéma électrique équivalent de cette cellule avec source S, drain D, grille G et grille flottante intermédiaire FG, à une distance très faible (0,01 micromètre) du drain sur une partie de sa longueur.

L'invention utilise pour constituer le fusible une structure tout à fait semblable, mais au lieu de programmer la cellule comme décrit ci-dessus, l'oxyde de tunnel est "claqué", une résistance de faible valeur est alors établie entre le drain et la grille FG. Pour cela les deux grilles G et FG sont interconnectées, et , de préférence, au lieu de monter la tension de programmation lentement, cette tension est montée rapidement. l'interconnexion des deux grilles permet de supprimer le couplage capacitif entre les deux grilles en établissant entre elles une liaison directe. De plus, l'une des bornes de la résistance formée par l'oxyde tunnel peut être mise à la masse. Ainsi, dans les mêmes conditions de tension appliquée que pour la cellule décrite ci-dessus utilisée en mémoire, un champ électrique de 20 MV/cm est obtenu entre G (et FG) et le drain D, ce qui est tout à fait suffisant pour obtenir le claquage de l'oxyde dans la fenêtre. De plus l'application rapide de la tension permet d'obtenir un très bon claquage de l'oxyde tunnel et donc une résistance entre drain et grille la plus faible possible. Cette condition d'application rapide de la tension de claquage n'est pas indispensable car, avec des tensions de cette amplitude l'oxyde de tunnel subira en tout état de cause un claquage ; néanmoins, lorsque la tension est appliquée plus lentement, le claquage est moins net et une résistance un peu plus élevée peut subsister entre drain et grille.

La figure 2a illustre en coupe la structure correspondante du fusible semblable à celle de la cellule mémoire, mais dans laquelle les deux grilles sont interconnectées. Elles sont marquées G1 et G2 sur cette figure car il n'y a plus de grille "flottante". La tension de claquage est appliquée entre la borne B (grilles) et la borne A (connexion de drain D sur la figure 1a). La zone dopée correspondant à la source S de la figure 1a n'est pas connectée. la figure 2b est le schéma électrique symbolique équivalent.

La figure 3 illustre le montage utilisé pour effectuer le claquage de l'oxyde qui fait passer le fusible de son état initial "ouvert" à son état "passant" lorsque nécessaire, cette transformation étant irréversible : le fusible F1 représenté comme montré sur la figure 2b a donc une borne non connectée, sa borne A reliée à une tension d'alimentation Vpp via un transistor T1 dont la grille est connectée à une borne de commande, COMVpp, et sa borne B reliée à la masse via un transistor T2 dont la grille est connectée à une borne de commande COMVss. Pour claquer ce "fusible" le signal de commande de T2,COMVpp, est augmenté jusqu'à la tension d'alimentation Vpp, alors que le signal de commande COMVss initialement à l'état haut, est ramené à 0. A l'instant t1 sur le chronogramme de la figure 4, le transistor T2 se bloque et T1 commence à conduire. La tension au noeud B reste flottante. Aucun champ électrique n'est alors généré à travers l'oxyde tunnel. A l'instant t2, la tension au noeud A est Vpp = 20V et la tension au noeud B est 0V. Un champ électrique intense 20 MV/cm existe donc dans la fenêtre tunnel qui claque rapidement. Une fuite vers la masse du détecteur de courant apparaît ; ce qui fait descendre le potentiel au noeud A. Le phénomène de claquage s'arrête alors.

En détection, la tension appliquée sur la grille de T1, COMVpp = 0V et le transistor T1 est bloqué. la tension appliquée sur la grille de T2, COMVss = 5V (il faut juste rendre T2 conducteur), ce qui porte les grilles (noeud B) de la cellule fusible F1 à Vss (OV).
- lorsque l'oxyde de la fenêtre tunnel est intact, il n'y a aucun courant dans la cellule fusible F1, et le détecteur de courant indique cette absence de courant ;
- lorsque l'oxyde est claqué, une faible résistance entre A et B existe, ce qui induit un courant I vers la masse du détecteur, un état différent est alors détecté.

Ce phénomène de claquage est irréversible. Aucun chauffage (recuit) du circuit ne peut changer la structure de l'oxyde claqué. De plus, comme l'effet n'est pas un stockage de charges, aucun essai de décharge ou de stockage de charges dans l'oxyde mince de la cellule ne peut affecter l'état de la cellule fusible. Ce claquage est rapide, 1ms, comparativement à la durée de programmation d'une cellule (Fig 1a) de l'ordre de 5ms, ou à la durée nécessaire au claquage d'un fusible classique de l'ordre de 100ms. Aucune puissance n'est nécessaire, et le générateur interne de tension Vpp étant utilisé pour le claquage de l'oxyde, il est possible dans le cadre d'une application aux circuits intégrés pour cartes, de prévoir de griller, un ou des fusibles du circuit dès qu'une anomalie est constatée, sans qu'un éventuel fraudeur puisse l'empêcher.

Une telle structure peut également être utilisée pour construire des mémoires EPROM à une seule programmation. Ainsi des cartes à mémoire peuvent être personnalisées par des changements irréversibles dans la structure des circuits par claquage d'oxyde. Habituellement, comme indiqué ci-dessus, lorsque la personnalisation est obtenue par des dispositions particulières lors de la fabrication, elle nécessite des opérations de masquage chères, lentes et peu souples, et lorsque la personnalisation est effectuée par programmation électrique de cellules EPROM ou EEPROM, les structures résultantes sont vulnérables.

Pratiquement pour transformer une cellule telle que représentée sur la figure 1a en fusible tel que représenté sur la figure 2a, il suffit lors de l'opération de dépôt d'oxyde de silicium sur la grille flottante de réserver une zone pour le contact entre les deux grilles, le contact étant obtenu lorsque le silicium polycrystallin de la deuxième grille est déposé dans la zone réservée. Une autre possibilité consisterait à prévoir des points de contacts accessibles sur la grille flottante de toutes les cellules de ce type, et de connecter ces points aux lignes de mots des seules cellules utilisées comme fusibles.

## Revendications

1. Utilisation d'une cellule MOS programmable électriquement pour réaliser un fusible, la cellule comportant deux électrodes (A,S) formées par dopage d'un substrat, une première grille (G2) formée de silicium-polycristallin recouvrant partiellement l'une (A) des deux électrodes dont elle est séparée par une couche d'oxyde de silicium amincie pour former une fenêtre tunnel (F), et une seconde grille (G1) séparée de la première par une couche d'oxyde, les deux grilles (G1, G2) étant interconnectées pour permettre l'application d'un champ électrique de claquage irréversible de l'oxyde formant la fenêtre (F).

2. Utilisation selon la revendication 1, caractérisé en ce que l'épaisseur de la fenêtre est de l'ordre de 0,01 micromètre, le champ électrique de claquage appliqué lorsqu'il y a lieu entre grille et électrode est supérieur à 12MV/cm.

3. Utilisation selon l'une quelconque des revendications précédentes, la cellule étant appliquée à des cartes à mémoires pour bloquer de manière irréversible, après personnalisation des cartes, l'accès à certaines zones de circuits de ces cartes.

4. Utilisation selon l'une quelconque des revendications 1 à 3, une pluralité des cellules étant appliquées à un réseau mémoire pour constituer ses points mémoires, ces points mémoires étant ainsi programmables par claquage d'oxyde.

## Patentansprüche

1. Verwendung einer elektrisch programmierbaren MOS-Zelle als Schmelzsicherung, wobei die Zelle zwei durch Dotierung eines Substrates gebildete Elektroden (A, S) aufweist, ein erstes Gitter (G2) aufweist, das aus polykristallinem Silizium besteht, welches einen Teil einer (A) der beiden Elektroden bedeckt, von der es durch eine verringerte Siliziumoxidschicht getrennt ist, um so eine Tunnelöffnung (F) zu erhalten und ein zweites Gitter (G1) aufweist, das vom ersten Gitter durch eine Oxidschicht getrennt ist, wobei die beiden Gitter (G1, G2) miteinander verbunden sind, um die Anlegung eines elektrischen, für das Oxid irreversiblen, die Öffnung (F) bildenden Durchschlagfeldes zu ermöglichen.

2. Verwendung nach Anspruch 1, dadurch gekennzeichnet, daß die Dicke der Öffnung in der Größenordnung von 0,01 Mikrometer liegt und daß das elektrische Durchschlagsfeld, das zwischen dem Gitter und der Elektrode angelegt wird, größer als 12 MV/cm ist.

3. Verwendung nach einem der vorhergehenden Ansprüche, wobei die Zelle Anwendung in Speicherkarten findet, um nach der Personalisierung dieser Karten den Zugriff zu bestimmten Schaltkreisbereichen der Karten in irreversibler Weise zu blockieren.

4. Verwendung nach einem der Ansprüche 1 bis 3, wobei eine Vielzahl von Zellen einem Speicherschaltkreis zugeordnet ist, um Speicherpunkte zu bilden, welche durch einen Oxiddurchschlag programmierbar sind.

## Claims

1. Use of an electrically programmable MOS cell to implement a fuse, the cell comprising two electrodes (A,S) formed by doping a substrate, a first grid (G2) formed by polycrystalline silicon and partly covering one (A) of the two electrodes, from which it is separated by a layer of thinned silicon in order to form a tunnel window (F), and a second grid (G1) separated from the first by a layer of oxide, the two grids (G1, G2) being interconnected in order to make it possible to apply an electric field of irreversible insulation breakdown of the oxide forming the window (F).

2. Use in accordance with claim 1, characterised by the fact that the thickness of the window is of the order of 0.01 micrometres, the electrical insulation breakdown field applied where necessary between the grid and the electrode being above 12 MV/cm.

3. Use in accordance with either of the preceding claims, the cell being applied to memory cards so that after the personalization of the cards access to certain zones of the circuits of these cards will be irreversibly blocked.

4. Use in accordance with any one of claims 1 to 3, a plurality of the cells being applied to a memory network in order to form its memory points, these memory points being thus programmable by insulation breakdown of oxide.
